# EUROPÄISCHE PATENTSCHRIFT

(11) **EP 0 873 557 B1**
(45) Veröffentlichungstag und Bekanntmachung des Hinweises auf die Patenterteilung: **16.08.2000**
(21) Anmeldenummer: 97947022.6
(22) Anmeldetag: 24.10.1997
(51) Int. Cl.: G09F 13/22, H01L 33/00

(54) **MEHRFARBIGES LICHT ABSTRAHLENDE BILDANZEIGEVORRICHTUNG**
IMAGE-DISPLAY DEVICE EMITTING MULTICOLOURED LIGHT
DISPOSITIF AFFICHEUR D'IMAGES DIFFUSANT UNE LUMIERE MULTICOLORE

(30) Priorität: 31.10.1996 DE 19645035
(43) Veröffentlichungstag der Anmeldung: 28.10.1998
(73) Patentinhaber: Osram Opto Semiconductors GmbH & Co. oHG, 93049 Regensburg (DE)
(72) Erfinder: AVERBECK, Robert, D-81371 München (DE); TEWS, Helmut, D-82008 Unterhaching (DE)
(74) Vertreter: Epping, Wilhelm, Dipl.-Ing.
(86) Internationale Anmeldenummer: DE9702478
(87) Internationale Veröffentlichungsnummer: WO9819290

(56) Entgegenhaltungen:
- EP-A- 0 488 753
- WO-A-97/48138
- WO-A-97/50132
- DE-A- 4 313 798
- DE-U- 9 013 615
- US-A- 5 523 589
- Y. SATO ET AL.: "Full-Color Fluorescent Display Devices Using a Near-UV Light-Emitting Diode" JAPANESE JOURNAL OF APPLIED PHYSICS, PART 2 LETTERS, Bd. 35, Nr. 7a, 1.Juli 1996, JP, Seiten L838-L839, XP002057391
- PATENT ABSTRACTS OF JAPAN vol. 96, no. 10, 31.Oktober 1996 & JP 08 167735 A (HITACHI CABLE LTD.), 25.Juni 1996,

## Beschreibung

Die Erfindung betrifft eine mehrfarbiges Licht abstrahlende Bildanzeigevorrichtung, insbesondere eine hochauflösende Bildanzeigevorrichtung, mit einer monolithisch integrierten Anordnung.

Als Ersatz für die derzeit verwendeten Kathodenstrahlröhren zur hochauflösenden farbigen Anzeige von Bildern werden derzeit Bildanzeigevorrichtungen mit einer monolithisch integrierten Anordnung entwickelt, die vermittels Halbleitertechnologie-Fertigungsschritten herstellbar sind und welche wegen einer deutlich verringerten Baugröße völlig neuen Anwendungsbereichen zugeführt werden können, beispielsweise Brillen mit eingebautem Farbdisplay oder dergleichen. Obzwar bereits Leuchtdioden oder dergleichen lichtemittierende Einzel-Halbleiter-Bauelemente, die in unterschiedlichen Farben leuchten, zur Verfügung stehen, bestehen bei der Herstellung von hochauflösenden mehrfarbigen Bildanzeigevorrichtungen erhebliche technologische Schwierigkeiten unter anderem deswegen, da Leuchtdioden für die drei Grundfarben Rot, Grün und Blau nicht mit einer einheitlichen Epitaxietechnik realisierbar sind. Aufgrund der großen Materialunterschiede der für die Herstellung solcher Displays benötigten, in unterschiedlichen Farben leuchtenden Einzel-Halbleiter-Bauelemente mit den Grundmaterialien GaAsP:N, InGaAlP, InGaAlN ist auch in Zukunft eine Lösung der technologischen Schwierigkeiten nicht zu erwarten. Die derzeit praktizierte Montage verschiedener fertiger Leuchtdioden-Chips auf einem Träger ist mit sehr hohen Kosten und im Übrigen auch mit einer nur geringen erreichbaren Auflösung verbunden.

Aus John A. van Raalte, Matrix TV displays: Systems and circuit problems, in: IEEE Transactions on Consumer Electronics, Vol. CE-21, No. 3, August 1975, S. 213 - 219 ist eine mehrfarbiges Licht abstrahlende Plasma-Bildanzeigevorrichtung bekannt, bei der UV-Licht abstrahlende Plasmaelemente mit Photolumineszenz-Phosphoren kombiniert sein können. Darüber hinaus sind Fernsehbildanzeigenvorrichtungen bekannt, bei denen Leuchtdioden in Form einer Matrix angeordnet sind.

Aus C. Reuber, Flachbildschirme ... der weite Weg zu Nipkows Vision, in: Fernseh- und Kino-Technik, 47. Jahrg., Nr. 4, 1993, S. 231 - 242 ist eine Fernsehbildwiedergabevorrichtung nach dem Prinzip der Gasentladungstechnik bekannt. In diesem Zusammenhang ist weiterhin bekannt, dass für eine vollfarbige Wiedergabe die orangerot leuchtende Neon-Argon-Mischung durch eine ultraviolette Strahlung erzeugende Gasmischung ersetzt und das UV mit Leuchtstoffen in die Grundfarben RGB transformiert werden muss.

Aus der DD 0151 828 ist bekannt, UV-Licht dadurch sichtbar zu machen, dass das ultraviolette Licht Photolumineszenz in einer geeigneten Stelle anregt.

Aus der DE 28 20 889 C2 sind lumineszierende Substanzen aus Oxiden von Alkalimetallen, seltenen Erden und Phosphor, und deren Verwendung in Kathodenstrahlenröhren sowie Vorrichtungen zur Umwandlung von UV-Licht in sichtbares Licht bekannt.

Aus SATO et Al, "Full Colour Fluorescent Display Devices using Near-UV Light Emitting Diode", Japanese Journal of Applied Physics, Vol 35, n°7a, July 96, ist die Technik vorgestellt worin die drei Grün, Rot und Blau von einem Film, unter Bestrahlung mit UV-Licht aus ein LED, emittiert werden wobei der Film mit einer Mischung von ZnS:Ag (für Blau), ZnS:Cu, Al (für Grün) und ZnCd S:Ag (für Rot) enthaltenden Fluor Pulvern versehen ist.

Der Erfindung liegt die Aufgabe zugrunde, eine technologisch einfach herzustellende, mehrfarbiges Licht abstrahlende Bildanzeigevorrichtung der eingangs genannten Art zur Verfügung zu stellen.

Diese Aufgabe wird durch eine Bildanzeigevorrichtung nach Anspruch 1 gelöst.

Erfindungsgemäß ist ein Träger vorgesehen, auf bzw. in dem eine Vielzahl von jeweils einzeln elektronisch ansteuerbaren Halbleiter-Leuchtdioden oder -Laserdioden ausgebildet ist, und den Halbleiter-Leuchtdioden oder -Laserdioden eine Mehrzahl von optisch voneinander getrennten Lumineszenzkonversionselementen mit Leuchtstoffen unterschiedlicher Farbe zugeordnet ist, die jeweils zumindest einen Teil eines von den Halbleiter-Leuchtdioden- oder -Laserdioden emittierten Lichtes absorbieren, in sichtbares Licht anderer Wellenlänge umwandeln und abstrahlen.

Dem Prinzip der Erfindung folgend ist vorgesehen, dass die Halbleiter-Leuchtdioden oder -Laserdioden im ultravioletten oder blauen Wellenlängenbereich emittieren. Der besondere Vorteil einer im UV-Wellenlängenbereich emittierenden Halbleiter-Leuchtdiode oder -Laserdiode besteht darin, dass sie keine oder deutlich weniger sichtbare und damit eventuell störende Reststrahlung aussendet. Anstelle einer im UV-Wellenlängenbereich emittierenden kann eine blaues Licht emittierende Halbleiter-Leuchtdiode oder Laserdiode verwendet werden.

Insbesondere ist vorgesehen, dass die auf dem Träger aufgebrachten Lumineszenzkonversionselemente abwechselnd mit Leuchtstoffen der Grundfarben ausgestattet sind, welche so ausgewählt sind, dass sich bei Bestrahlung insbesondere mit UV-Licht das gesamte sichtbare Spektrum abdecken lässt. Insbesondere kann hierbei vorgesehen sein, dass als Farbstoffe für die in den Grundfarben Rot, Grün, Blau leuchtenden Lumineszenzkonversionselemente ZnS:Ag, ZnS:Cu,Al bzw. ZnCdS:Ag verwendet werden. Ebenso können als Leuchtstoffe aber auch Phosphore, wie beispielsweise YAG:Ce und andere mit seltenen Erden dotierte Granate, Thiogallate, Aluminate oder Orthosilikate verwendet sein.

Im Falle der Verwendung von im UV-Wellenlängenbereich emittierenden Halbleiter-Leuchtdioden oder -Laserdioden sind die Lumineszenzkonversionselemente abwechselnd mit Leuchtstoffen der drei Grundfarben Rot, Grün, Blau ausgestattet. Im Falle von blaues Licht emittierenden Halbleiter-Leuchtdioden oder -Laserdioden werden an sich nur noch die zwei Grundfarben Grün und Rot für die Luminezenzkonversionselemente benötigt, da die Grundfarbe blau bereits von den Leuchtdioden oder Laserdioden abgestrahlt wird.

Bei einer besonders einfach herzustellenden Ausführung der Erfindung kann vorgesehen sein, dass die Lumineszenzkonversionselemente auf der der Halbleiter-Leuchtdioden- oder -Laserdiodeneinrichtung abgewandten Seite des Trägers aufgebracht sind.

Von Vorteil ist vorgesehen, dass der durchsichtige bzw. wenigstens durchscheinende Träger durch ein Saphir-Substrat ausgebildet ist. Das als Substratmaterial von Vorteil zum Einsatz gelangende Saphir ist relativ kostengünstig in großen Flächen verfügbar (typischerweise sind Scheibendurchmesser von drei Zoll und mehr erhältlich) und bietet aufgrund seiner ausgesprochen hohen mechanischen Stabilität die neben den elektronischen Eigenschaften gleichzeitig geforderten mechanischen Eigenschaften.

Eine höhere Trennschärfe zwischen den einzelnen Farbpixeln, insbesondere bei dickeren Trägern, ist von Vorteil dann zu erreichen, wenn die Halbleiter-Leuchtdioden oder -Laserdioden und die Lumineszenzkonversionselemente auf der selben Seite des Trägers angeordnet sind. In diesem Fall kann der Träger auch aus undurchsichtigem Material bestehen und/oder mit einer ganzflächigen Spiegelschicht versehen sein, mit welcher der Verlustanteil der nicht verwendbaren Lichtleistung verringert werden kann. Im Falle eines transparenten Trägers ist die Spiegelschicht zweckmäßigerweise auf der Rückseite des Trägers, also auf der den Lumineszenzkonversionselementen abgewandten Seite des Trägers aufgebracht.

Bei einer besonders bevorzugten Ausgestaltung der Erfindung, bei der die Luminenszenzkonversionselemente und die Leuchtdioden auf derselben Seite des Trägers ausgebildet sind, ist eine Kontaktschicht aus transparentem bzw. wenigstens durchscheinenden Material vorgesehen. Die normalerweise undurchsichtigen Anschlussleitungen überdecken in diesem Fall nur einen Teil des Anschlussbereiches für die Halbleiter-Leuchtdioden- bzw. -Laserdioden. Zur Stromverbreiterung und damit optimaleren Einkopplung des elektrischen Stromes dient dann diese transparente bzw. wenigstens durchscheinende Kontaktschicht. Die Farbstoffe der Luminenszenzkonversionselemente können zweckmäßig direkt auf diese transparente Kontaktschicht, oder auch auf eine Zwischenschicht, oder eingebettet in einer speziellen Vergussmasse aufgebracht sein.

Von Vorteil kann weiterhin vorgesehen sein, dass das Grundmaterial der monolithisch integrierten Halbleiter-Leuchtdioden- oder -Laserdioden Galliumnitrit GaN oder einen Abkömmling hiervon wie beispielsweise InGaN oder AlGaN aufweist. Da das Halbleitermaterial GaN auch für Anwendungen der Leistungselektronik geeignet ist, ermöglicht diese Ausbildung gleichzeitig eine Integration von Leitungstreiberschaltungen oder elektronischen Ansteuerungsschaltungen.

Von Vorteil kann ferner vorgesehen sein, dass die auf oder in dem Träger ausgebildeten Halbleiter-Leuchtdioden oder -Laserdioden eine Schichtenfolge aus Halbleitermaterialien, insbesondere eine Schichtenfolge mit einer aktiven Schicht aus GaₓIn₁₋ₓN oder GaₓAl₁₋ₓN aufweisen, die eine elektromagnetische Strahlung der Wellenlänge kleiner oder gleich 480 nm, insbesondere kleiner oder gleich 370 nm, aussenden, wobei das Lumineszenzkonversionselement die Strahlung eines ersten spektralen Teilbereiches der von der Leuchtdioden oder -Laserdioden ausgesandten, aus einem ersten Wellenlängenbereich stammenden Strahlung in Strahlung eines zweiten Wellenlängenbereiches umwandelt. Das heißt zum Beispiel, dass das Lumineszenzkonversionselement eine von den Leuchtdioden ausgesandte Strahlung spektral selektiv absorbiert und im längerwelligen Bereich (im zweiten Wellenlängenbereich) emittiert. Idealerweise weist die von den Leuchtdioden ausgesandte Strahlung bei einer Wellenlänge von kleiner gleich 370 nm ein Strahlungsmaximum auf. Ein besonderer Vorteil der erfindungsgemäßen Bildanzeigevorrichtung liegt auch darin, dass das über Lumineszenzkonversion erzeugte Wellenlängenspektrum und damit die Farbe des abgestrahlten Lichtes nicht von der Höhe der Betriebsstromstärke durch die Halbleiterleuchtdioden oder -Laserdioden abhängt. Dies hat insbesondere dann große Bedeutung, wenn die Umgebungstemperatur des Halbleiter-Bauelementes und damit bekanntermaßen auch die Betriebsstromstärke stark schwankt. Besonders Leuchtdioden mit einem Halbleiterkörper auf der Basis von GaN sind diesbezüglich empfindlich. Außerdem benötigt die erfindungsgemäße Bildanzeigevorrichtung lediglich eine einzige Ansteuerspannung und damit auch nur eine einzige Ansteuerschaltungsanordnung, wodurch der Bauteileaufwand sehr gering gehalten werden kann.

Bei einer weiteren bevorzugten Weiterbildung der erfindungsgemäßen Bildanzeigevorrichtung sind dem Lumineszenzkonversionselement oder einer anderen strahlungsdurchlässigen Komponente der Bauteilumhüllung zusätzlich lichtstreuende Partikel, sogenannte Diffusoren zugesetzt. Hierdurch lässt sich vorteilhafterweise der Farbeindruck und die Abstrahlcharakteristik der Bildanzeigevorrichtung optimieren.

Von besonderem Vorteil emittieren die auf bzw. in dem Träger ausgebildeten Halbleiter-Leuchtdioden oder -Laserdioden UV-Licht mit Wellenlängen von kleiner oder gleich 370 nm. Hierbei ist eine vollständige Umwandlung des UV-Lichtes durch die Lumineszenzkonversionselemente nicht erforderlich, da der ultraviolette Anteil nicht zu Farbveränderungen im sichtbaren Spektrum führt. Im Übrigen kann durch Versiegeln mit einem UV-undurchsichtigen Lack oder durch eine Montage der Bildanzeigevorrichtung hinter einer Glasscheibe ein gegebenenfalls verbleibender Anteil des ausgesandten UV-Lichtes einfach ausgefiltert werden.

Weitere Merkmale, Vorteile und Zweckmäßigkeiten der Erfindung ergeben sich aus der nachfolgenden Beschreibung von Ausführungsbeispielen. Es zeigt:
- Figur 1: eine schematische Darstellung einer hochauflösenden, mehrfarbiges Licht abstrahlenden Bildanzeigevorrichtung, eines sogenannten True Color Displays; und
- Figur 2: eine schematische Schnittansicht einer weiteren Ausführungsform eines True Color Displays, bei der die Leuchtdioden und die Lumineszenzkonversionselemente auf derselben Seite eines vollflächig verspiegelten Trägers ausgebildet sind.

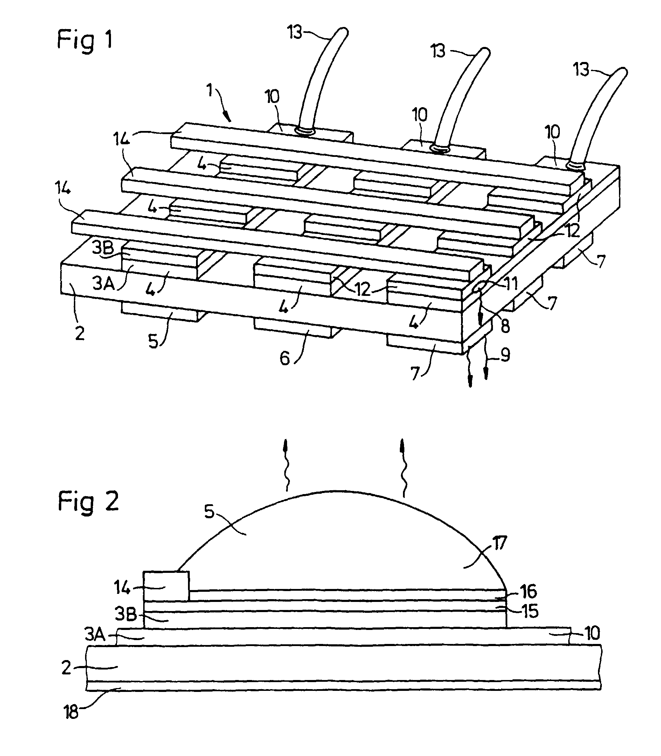

Die in den Figuren 1 und 2 dargestellten Bildanzeigevorrichtungen umfassen eine monolithisch integrierte Anordnung 1, ein sogenanntes Array, bestehend aus einem durchsichtigen bzw. wenigstens durchscheinenden Träger 2 aus einem großflächigem Saphir-Substrat, welches relativ kostengünstig mit Scheibendurchmessern von typischerweise drei Zoll und mehr verfügbar ist, einer aus GaN-Grundmaterial bestehenden Halbleiter-Leichtquelle mit einer Vielzahl von matrixförmig auf dem Träger 2 angeordneten, elektronisch einzeln ansteuerbaren, im UV-Wellenlängenbereich emittierenden Halbleiter-Leuchtdioden oder -Laserdioden 4, von denen jede einen n-leitenden Bereich 3A und einen p-leitenden Bereich 3B besitzt, sowie eine Vielzahl von Lumineszenzkonversionselementen 5, 6, 7 mit Leuchtstoffen unterschiedlicher Farbe, die das von den Halbleiter-Leuchtdioden oder -Laserdioden 4 im UV-Wellenlängenbereich emittierte Licht 8 empfangen, in sichtbares Licht 9 umwandeln und wie schematisch dargestellt in einer Richtung quer zur Ebene des Saphir-Trägers 2 abstrahlen. Bei den dargestellten Ausführungsbeispielen besitzt jedes Lumineszenzkonversionselement 5 einen Leuchtstoff der Grundfarbe Rot, jedes Lumineszenzkonversionselement 6 einen Leuchtstoff der Grundfarbe Grün, und jedes Lumineszenzkonversionselement 7 einen Leuchtstoff der Grundfarbe Blau. Jeweils ein Tripel der Lumineszenzkonversionselemente 5, 6, 7 stellt somit einen Bildpunkt bzw. Pixel der Bildanzeigevorrichtung dar und ermöglicht die Abstrahlung vollfarbiger Bilder, wobei in an sich bekannter Weise vermittels geeigneter Leuchtstoffe für drei Grundfarben das gesamte sichtbare Spektrum dargestellt werden kann. Neben den drei bevorzugt verwendeten Grundfarben Rot, Grün und Blau sind selbstverständlich auch andere geeignete Grundfarben realisierbar, ohne das Grundprinzip der Erfindung zu verlassen. Geeignete Materialien für die Farbstoffe der in den drei Grundfarben Rot, Grün, Blau leuchtenden Lumineszenzkonversionselemente 5, 6, 7 sind beispielsweise ZnS:Ag, ZnS:Cu,Al und ZnCdS:Ag.

Die im UV-Wellenlängenbereich emittierenden Halbleiter-Leuchtdioden 4 umfassen vermittels an sich bekannter Halbleitertechnologie-Fertigungsschritte unmittelbar auf der einen Seite des Trägers 2 streifenförmig strukturierte Spalten 10 aus n-dotiertem GaN-Material, auf denen zur Ausbildung eines pn-Übergangs bzw. UV-Licht erzeugenden Bereiches 11 p-dotiertes GaN-Material 12 zur Ausbildung von Zeilen strukturiert ist. Die elektronische Ansteuerung der einzelnen Leuchtdioden bzw. Laserdioden 4 erfolgt über metallische Spaltenleitungen 13 und Zeilenleitungen 14 in Form von Metallbahnen, welche mit an sich bekannten Halbleitertechnologie-Strukturierungs- und Fertigungsmaßnahmen hergestellt werden, und welche zur Ansteuerung der einzelnen Bildpunkte mit Spalten- und Zeilen-adress-Signalen von einer (nicht näher dargestellten) Ansteuerschaltung versorgt werden.

Jedes Lumineszenzkonversionselement kann beispielsweise aus einem transparenten Epoxidharz oder auch Silikon-, Thermoplast- oder Duroplastmaterial bestehen, das mit geeigneten organischen oder anorganischen Farbstoffmolekülen versehen ist. Vorteilhafterweise lassen sich insbesondere anorganische Leuchtstoffe in Epoxidharz auf einfache Weise homogen verteilen. Die Lumineszenzkonversionselemente 5, 6, 7 werden in konstanter Stärke und mit gleichen Grundflächen vorzugsweise durch Siebdruck oder andere kostengünstig durchzuführende Verfahren auf den Träger 2 aufgebracht.

Bei dem Ausführungsbeispiel nach Figur 1 sind die Halbleiter-Leuchtdioden 4 und die Lumineszenzkonversionselemente 5, 6, 7 auf den beiden Seiten des plattenförmigen Trägers 2 ausgebildet. Der Träger besteht hierbei aus einem durchsichtigen bzw. wenigstens durchscheinenden Material wie beispielsweise Saphir.

Bei dem Ausführungsbeispiel gemäß Figur 2 sind die Leuchtdioden 4 und die Lumineszenzkonversionselemente 5 auf derselben Seite des Trägers angeordnet. Diese Bauform besitzt vor allem dann Vorteile, wenn die Trennschärfe zwischen den einzelnen Farbpixeln beispielsweise auf Grund eines dickeren Trägers nicht ausreichend sein sollte. Die Zeilenleitungen 14 für die elektrische Verbindung des p-leitenden Bereiches 3B jeder Leuchtdiode 4 überdecken in diesem Fall nur einen Teil des oberen, p-leitenden Bereiches 3B. Zur Stromverbreiterung sind transparente Kontaktschichten 15 aus elektrisch leitendem Material vorgesehen, die den p-leitenden Bereich 3B jeder Leuchtdiode 4 überdecken. Auf der Kontaktschicht 15 ist das Lumineszenzkonversionselement 5 angeordnet; bei der dargestellten Ausführung ist der Farbstoff 16 direkt auf die Kontaktschicht 15 aufgebracht und mit einer transparenten Deckschicht 17 überzogen. Das Material für die elektrisch leitende transparente Kontaktschicht 15 kann beispielsweise Indium-Zinn-Oxid aufweisen; alternativ kann die Kontaktschicht 15 auch aus einer dünnen, durchsichtigen Goldschicht bestehen. Genauso zweckmäßig kann der Farbstoff auch in einem Kunstharz oder dergleichen geeigneten Material eingebettet sein, welches Material die Kontaktschicht 15 (und gegebenenfalls einen geringen Teil der Zeilenleitung 14) überdeckt.

Um auch das nach unten emittierte Licht zu nutzen, kann die Rückseite des Trägers 2 großflächig mit einer Spiegelschicht 18 versehen sein.

### Bezugszeichenliste

- 1: monolithisch integrierte Anordnung
- 2: Träger
- 3A: n-leitender Bereich
- 3B: p-leitender Bereich
- 4: Halbleiter-Leuchtdioden oder -Laserdioden
- 5, 6, 7: Lumineszenzkonversionselemente
- 8: emittiertes Licht
- 9: sichtbares Licht
- 10: Spalten
- 11: pn-Übergang
- 12: GaN-Material
- 13: Spaltenleitungen
- 14: Zeilenleitungen
- 15: Kontaktschichten
- 16: Farbstoff
- 17: Deckschicht
- 18: Spiegelschicht

## Patentansprüche

1. Mehrfarbiges Licht abstrahlende Bildanzeigevorrichtung worin ein Träger (2) vorgesehen ist, auf bzw. in dem eine Vielzahl von jeweils einzeln elektronisch ansteuerbaren Halbleiter-Leuchtdioden (4) oder -Laserdioden ausgebildet ist, wobei den Halbleiter-Leuchtdioden (4) oder Laserdioden (3) eine Mehrzahl von optisch voneinander getrennten Lumineszenzkonversionselementen (5, 6, 7) mit Leuchtstoffen unterschiedlicher Farbe zugeordnet ist, die jeweils zumindest einen Teil eines von den Halbleiter-Leuchtdioden (4) oder -Laserdioden emittierten Lichtes (8) absorbieren, in sichtbares Licht (9) anderer Wellenlänge umwandeln und abstrahlen.

2. Bildanzeigevorrichtung nach Anspruch 1, **dadurch gekennzeichnet**, dass die Halbleiter-Leuchtdioden (4) oder -Laserdioden im ultravioletten oder blauen Wellenlängenbereich emittieren.

3. Bildanzeigevorrichtung nach einem der Ansprüche 1 bis 2, **dadurch gekennzeichnet**, dass die auf bzw. in dem Träger (2) aufgebrachten Lumineszenzkonversionselemente (5, 6, 7) abwechselnd mit Leuchtstoffen der wenigstens zwei Grundfarben Rot und Grün oder der drei Grundfarben Rot, Grün und Blau ausgestattet sind.

4. Bildanzeigevorrichtung nach Anspruch 3, **dadurch gekennzeichnet**, dass als Farbstoffe für die in den Grundfarben Rot, Grün, Blau leuchtenden Lumineszenzkonversionselemente (5, 6, 7) ZnS:Ag, ZnS:Cu,Al bzw. ZnCdS:Ag verwendet wird.

5. Bildanzeigevorrichtung nach einem der Ansprüche 1 bis 4, **dadurch gekennzeichnet**, dass das Grundmaterial der auf bzw. in dem Träger monolithisch integrierten Halbleiter-Leuchtdioden oder -Laserdioden (3) GaN aufweist.

6. Bildanzeigevorrichtung nach einem der Ansprüche 1 bis 5, **dadurch gekennzeichnet**, dass der Träger (2) durchsichtig bzw. wenigstens durchscheinend ausgebildet ist und dass die Lumineszenzkonversionselemente (5, 6, 7) auf der den Halbleiter-Leuchtdioden oder -Laserdioden (4) abgewandten Seite des Trägers (2) aufgebracht sind.

7. Bildanzeigevorrichtung nach einem der Ansprüche 1 bis 5, **dadurch gekennzeichnet**, dass die Lumineszenzkonversionselemente (5, 6, 7) auf derselben Seite des Trägers (2) wie die Halbleiter-Leuchtdioden (4) oder Laserdioden aufgebracht sind, und eine durchsichtige bzw. wenigstens durchscheinende, elektrisch leitende Kontaktschicht (15) für die einzelnen elektronisch ansteuerbaren Halbleiter-Leuchtdioden (4) oder Laserdioden vorgesehen ist.

8. Bildanzeigevorrichtung nach einem der Ansprüche 1 bis 7, **dadurch gekennzeichnet**, dass der Träger (2) großflächig verspiegelt ist.

9. Bildanzeigevorrichtung nach einem der Ansprüche 1 bis 8, **dadurch gekennzeichnet**, dass die Vielzahl der auf dem Träger (2) ausgebildeten Halbleiter-Leuchtdioden oder -Laserdioden (4) zeilen- und spaltenweise angeordnet und elektrisch ansteuerbar sind.

## Claims

1. Image display device radiating multicoloured light, in which there is a support (2) which holds or contains a multiplicity of semiconductor light-emitting diodes (4) or semiconductor laser diodes which can each be individually electronically driven, the semiconductor light-emitting diodes (4) or laser diodes having an associated plurality of luminescence conversion elements (5, 6, 7) which are optically isolated from one another and have differently coloured luminescent materials, each absorbing at least part of a light (8) emitted by the semiconductor light-emitting diodes (4) or semiconductor laser diodes, converting it into visible light (9) of another wavelength and radiating it.

2. Image display device according to Claim 1, characterized in that the semiconductor light-emitting diodes (4) or semiconductor laser diodes emit in the ultraviolet or blue wavelength range.

3. Image display device according to one of Claims 1 to 2, characterized in that the luminescence conversion elements (5, 6, 7) mounted on or in the support (2) are alternately equipped with luminescent materials of the at least two base colours red and green or of the three base colours red, green and blue.

4. Image display device according to Claim 3, characterized in that the colorants used for the luminescence conversion elements (5, 6, 7) emitting light in the base colours red, green, blue are ZnS:Ag, ZnS:Cu,Al and ZnCdS:Ag.

5. Image display device according to one of Claims 1 to 4, characterized in that the base material of the semiconductor light-emitting diodes or semiconductor laser diodes (4) monolithically integrated on or in the support contains GaN.

6. Image display device according to one of Claims 1 to 5, characterized in that the support (2) is of transparent or at least translucent design, and in that the luminescence conversion elements (5, 6, 7) are mounted on that side of the support (2) which is remote from the semiconductor light-emitting diodes or semiconductor laser diodes (4).

7. Image display device according to one of Claims 1 to 5, characterized in that the luminescence conversion elements (5, 6, 7) are mounted on the same side of the support (2) as the semiconductor light-emitting diodes (4) or laser diodes, and a transparent or at least translucent electrically conductive contact layer (15) is provided for the individual electronically driveable semiconductor light-emitting diodes (4) or laser diodes.

8. Image display device according to one of Claims 1 to 7, characterized in that the support (2) is reflective over a large area.

9. Image display device according to one of Claims 1 to 8, characterized in that the multiplicity of semiconductor light-emitting diodes or semiconductor laser diodes (4) formed on the support (2) are arranged in rows and columns and can be driven electrically.

## Revendications

1. Dispositif d'affichage d'images émettant de la lumière multicolore, dans lequel il est prévu un support (2) sur lequel ou dans lequel est réalisée une pluralité de diodes (4) luminescentes à semi-conducteurs ou de diodes laser à semi-conducteurs pouvant être commandées chacune individuellement de manière électronique, une pluralité d'éléments (5, 6, 7) de conversion de luminescence séparés les uns des autres du point de vue optique et comportant des substances luminescentes de couleurs différentes qui chacune absorbe au moins une partie d'une lumière (8) émise par les diodes (4) luminescentes à semi-conducteurs ou les diodes laser à semi-conducteurs, la convertissent en lumière (9) visible d'une autre longueur d'onde et l'émettent, étant associées aux diodes (4) luminescentes à semi-conducteurs ou aux diodes (3) laser.

2. Dispositif d'affichage d'images suivant la revendication 1, caractérisé en ce que les diodes (4) luminescentes à semi-conducteurs ou les diodes laser à semi-conducteurs émettent dans la gamme de longueur d'onde ultraviolette ou bleue.

3. Dispositif d'affichage d'images suivant l'une des revendications 1 à 2, caractérisé en ce que les éléments (5, 6, 7) de conversion de luminescence déposés sur ou dans le support (2) sont munis en alternance de substances luminescentes des au moins deux couleurs de base rouge et verte ou des trois couleurs de base rouge, verte et bleue.

4. Dispositif d'affichage d'images suivant la revendication 3, caractérisé en ce que l'on utilise comme colorants pour les éléments (5, 6, 7) de conversion de luminescence éclairant dans les couleurs de base rouge, verte, bleue ZnS:Ag, NsS:Cu, ou et ZnSCdS:Ag.

5. Dispositif d'affichage d'images suivant l'une des revendications 1 à 4, caractérisé en ce que le matériau de base des diodes luminescentes à semi-conducteurs ou des diodes (3) laser à semi-conducteurs intégré de manière monolithique sur ou dans le support comporte du GaN.

6. Dispositif d'affichage d'images suivant l'une des revendications 1 à 5, caractérisé en ce que le support (2) est réalisé de manière transparente ou au moins de manière translucide et en ce que les éléments (5, 6, 7) de conversion de luminescence sont déposés du côté du support (2) éloigné des diodes luminescentes à semi-conducteurs ou des diodes (4) laser à semi-conducteurs.

7. Dispositif d'affichage d'images suivant l'une des revendications 1 à 5, caractérisé en ce que les éléments (5, 6, 7) de conversion de luminescence sont déposés du même côté du support (2) de que les diodes (4) luminescentes à semi-conducteurs ou les diodes laser, et en ce qu'il est prévu une couche de contact conductrice de l'électricité, transparente ou au moins translucide, pour les diodes (4) luminescentes à semi-conducteurs ou les diodes laser individuelles pouvant être commandées de manière électronique.

8. Dispositif d'affichage d'images suivant l'une des revendications 1 à 7, caractérisé en ce que le support (2) est muni d'une surface réfléchissante sur une grande surface.

9. Dispositif d'affichage d'images suivant l'une des revendications 1 à 8, caractérisé en ce que la pluralité des diodes luminescentes à semi-conducteurs ou des diodes (4) laser à semi-conducteurs réalisées sur le support (2) sont montées en lignes et en colonnes et peuvent être commandées de manière électrique.
